(19) Europäisches Patentamt

European Patent Office

Office européen des brevets

(11) **EP 4 293 915 B1**

(12) **EUROPÄISCHE PATENTSCHRIFT**

(45) Veröffentlichungstag und Bekanntmachung des Hinweises auf die Patenterteilung:
**21.01.2026  Patentblatt 2026/04**

(21) Anmeldenummer: **23172268.7**

(22) Anmeldetag: **09.05.2023**

(51) Internationale Patentklassifikation (IPC):
**H03M 1/50** *(2006.01)*        **G01R 19/252** *(2006.01)*

(52) Gemeinsame Patentklassifikation (CPC):
**G01R 19/252; H03M 1/508;** G01R 19/2503;
G01R 19/255

(54) **SPANNUNGSMESSANORDNUNG MIT EINEM MIKROCONTROLLER**

VOLTAGE MEASURING ARRANGEMENT WITH A MICROCONTROLLER

DISPOSITIF DE MESURE DE TENSION COMPRENANT UN MICROCONTRÔLEUR

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **14.06.2022  DE 102022114936**

(43) Veröffentlichungstag der Anmeldung:
**20.12.2023  Patentblatt 2023/51**

(73) Patentinhaber: **Pepperl+Fuchs SE**
**68307 Mannheim (DE)**

(72) Erfinder:
• **Delic, Edin**
**68307 Mannheim (DE)**
• **Schulz, Enrico**
**68307 Mannheim (DE)**
• **Elter, Johann**
**68307 Mannheim (DE)**
• **Seefried, Roland**
**68307 Mannheim (DE)**

(74) Vertreter: **Banse & Steglich**
**Patentanwälte PartmbB**
**Patentanwaltskanzlei**
**Herzog-Heinrich-Straße 23**
**80336 München (DE)**

(56) Entgegenhaltungen:
DE-A1- 2 826 723        FR-A1- 2 977 748
GB-A- 1 397 288         US-A1- 2014 015 513
US-B1- 6 348 798

## Beschreibung

Technisches Gebiet

Die Erfindung betrifft eine Anordnung zur Spannungsmessung, insbesondere unter Verwendung eines Mikrocontrollers.

Technischer Hintergrund

Mikrocontroller werden in vielen Technikgebieten zur Steuerung, Regelung oder Betreiben von technischen Systemen eingesetzt. Mikrocontroller bieten die Möglichkeit, Algorithmen zu implementieren, die sensorisch erfasste Messgrößen auswerten und z.B. zur Ansteuerung einer Aktorik verwenden. Mikrocontroller stellen im Unterschied zu Mikroprozessoren zusätzliche Möglichkeiten zur Messgrößenerfassung bereit, um diese an den Einsatzzweck in dem technischen System anzupassen.

Häufig werden Messgrößen von externen Sensoren in Form von Spannungssignalen bereitgestellt, die mithilfe einer in dem Mikrocontroller implementierten Spannungsmessschaltung gemessen und weiterverarbeitet werden können. So kann beispielsweise eine Temperaturmessung mithilfe eines temperaturabhängigen Widerstands (NTC oder PTC) vorgenommen werden, der in einer Widerstandsbrücke verschaltet ist. Ein Nachteil von einer in einem Mikrocontroller üblicherweise vorgesehenen Spannungsmessschaltung besteht darin, dass diese auf einen Messspannungsbereich beschränkt ist, der durch den Bereich der Betriebsspannung des Mikrocontrollers, oftmals einer separaten Versorgung des ADCs vorgegeben ist. Da die untere Spannungsgrenze (0V) immer gleich ist, ist somit der Messbereich nicht vollständig frei wählbar.

Beispielsweise ermöglicht ein 12-Bit-Analog-Digital-Wandler eine Spannungsmessung in einem Messbereich zwischen 0 und 5 V mit Spannungsinkrementen von $\frac{5\,V}{4096}=0{,}00122V$ . Soll beispielsweise eine Messspannung nur in dem Bereich zwischen 2 und 2,5 V erfasst werden, so reduziert sich dadurch die relative Auflösung in diesem Bereich auf etwa 9 Bits.

Die Druckschrift FR 2 977 748 A1 offenbart einen elektronischen Schaltkreis, umfassend eine Hauptspannungsquelle und einen Komparator, der so konfiguriert ist, dass er in zwei Betriebsarten arbeitet. Der Komparator umfasst einen ersten Eingang, der von der Hauptspannungsquelle gespeist wird, einen zweiten Eingang, der mit einer Referenzspannungsquelle verbunden ist, und einen Ausgang, der die Zustandsspannung des Komparators liefert. Ein Kondensator ist mit dem ersten Eingang des Komparators so verbunden, dass er von der Hauptspannungsquelle geladen werden kann, wenn sich der Komparator in der ersten Betriebsart befindet. Es ist eine Stufe vorgesehen, die die Entladung des Kondensators ermöglicht, wenn sich der Komparator in der zweiten Betriebsart befindet, wobei das Verhältnis zwischen dem Wert der Spannung über der Hauptspannungsquelle und dem Wert der Spannung über der Referenzspannungsquelle so bestimmt wird, dass sich die Spannung über dem Kondensator beim Laden desselben im Wesentlichen linear mit der Zeit ändert.

Die Druckschrift US 6 348 798 B1 offenbart eine Spannungsmessschaltung, die zum Messen eines Spannungspegels einer Spannungsquelle konfiguriert ist, umfassend: (a) einen Kondensator, der sich von der Spannungsquelle auflädt; (b) einen Widerstand, der zwischen die unbekannte Spannungsquelle und den Kondensator geschaltet ist; (c) einen Schalter, der mit dem Kondensator nebenschlussgekoppelt ist, um den Kondensator zu entladen, nachdem der Kondensator eine Schwellenspannung erreicht hat; und (d) einen Mikrocontroller, der so konfiguriert ist, dass er den Schalter steuert und eine Zeitspanne misst, die erforderlich ist, um den Kondensator über den Widerstand auf die Schwellenspannung aufzuladen, wobei die Zeit, die erforderlich ist, um den Kondensator auf die Schwellenspannung aufzuladen, verwendet wird, um den Spannungspegel der unbekannten Spannungsquelle unter Verwendung mindestens eines gespeicherten Kalibrierungsdatenwertes zu bestimmen.

Die Druckschrift DE 28 26 723 A1 offenbart ein Verfahren zur Temperaturmessung mit einem Heißleiter, wobei ein Kondensator bis zu einer der augenblicklichen Größe des Heißleiters proportionalen Spannung aufgeladen und danach über einen Widerstand vorbestimmter Größe auf einen vorgegebenen Wert entladen wird, wobei die zur Entladung auf den vorgegebenen Wert erforderliche Zeitspanne gemessen wird, die dem natürlichen Logarithmus des Widerstandswertes des Heißleiters entspricht, und wobei aus der Zeitspanne die Temperatur des Heißleiters abhängig von dem Widerstandswert des Heißleiters ermittelt wird.

In Druckschrift US 2014/015513 A1 offenbart eine Sensoranordnung zur Messung einer elektrischen Spannung, wobei ein Potentialpunkt, an dem die elektrische Spannung gegenüber einem definierten elektrischen Potential zu messen ist, mit einem Kondensator verbunden ist, an den eine Komparatoreinheit angeschlossen ist, die detektiert, ob an dem Kondensator eine erste definierte Schwellenspannung anliegt, wobei die Sensoranordnung derart ausgestaltet ist, dass sie ein Ausgangssignal liefert, das von mindestens einem Ladevorgang des Kondensators abhängt und mindestens die Information über die Ladezeit zum Aufladen des Kondensators auf die erste definierte Schwellenspannung umfasst, wobei die zu messende Spannung den Kondensator über einen zwischengeschalteten Ladewiderstand auflädt und der Kondensator anschließend entladen wird, wobei das Ausgangssignal der Sensoranordnung zumindest die Information über die Ladezeit enthält, in der der Kondensator bis zum Erreichen der ersten definierten Schwellenspannung, die von der Komparatoreinheit erfasst wird, geladen wird.

Die Druckschrift GB 1 397 288 A offenbart einen Analog-Digital-Wandler mit einem Komparator mit einem ersten und einem zweiten Eingang und einem Ausgang, einem ersten und einem zweiten Schalter zum abwechselnden Verbinden eines ersten und eines zweiten Signalpegels mit dem ersten Eingang, wobei der zweite Signalpegel als ein erster Referenzpegel verwendet wird. Eine Speichervorrichtung ist zwischen den zweiten Eingang und einen zweiten Referenzpegel geschaltet. Eine Stromgeneratoreinrichtung liefert entweder einen positiven oder einen negativen Strom an den zweiten Eingang, um die Speichervorrichtung aufzuladen, bis eine Zustandsänderung am Ausgang des Komparators auftritt. Eine Wähleinrichtung bestimmt die Polarität des Stroms aus der Generatoreinrichtung in Abhängigkeit vom Zustand des Ausgangssignals des Komparators und eine Zähleinrichtung bestimmt die Anzahl von Zählimpulsen, die von einem Impulsgenerator während einer Zählperiode abgegeben werden, die der Periode entspricht, für die die Stromgeneratoreinrichtung an den Komparator angelegt wird, bevor die Zustandsänderung des Komparators auftritt.

Es ist daher Aufgabe der vorliegenden Erfindung, auch für kleinere Spannungsmessbereiche insbesondere bei geringeren Differenzspannungen eine ausreichend präzise Spannungsmessung mit einem Mikrocontroller zu ermöglichen. Insbesondere sollen die Messbereiche anpassbar sein und eine hochaufgelöste Spannungsmessung in dem angepassten Messbereich ermöglichen.

Offenbarung der Erfindung

Diese Aufgabe wird durch die Spannungsmessanordnung mit einem Mikrocontroller nach Anspruch 1 gelöst, der in einfacher Weise eine Spannungsmessung mit einer messbereichsunabhängigen Auflösung auch in reduzierten Spannungsmessbereichen ermöglicht.

Weitere Ausgestaltungen sind in den abhängigen Ansprüchen angegeben.

Gemäß einem ersten Aspekt ist eine Spannungsmessanordnung, insbesondere zur Nutzung mit einem Mikrocontroller, zum Messen und Digitalisieren eines Messspannungspotenzials oder einer Messspannung vorgesehen, umfassend:

- eine Referenzspannungsquelle zum Bereitstellen eines Referenzspannungspotenzial oder einer Referenzspannung,
- einen Komparator mit einem ersten Eingang, einem zweiten Eingang und einen Komparatorausgang zum Ausgeben eines hohen Pegels oder eines niedrigen Pegels eines Komparatorausgangssignals abhängig von einem Vorzeichen einer Spannungsdifferenz zwischen dem ersten und dem zweiten Eingang;
- ein RC-Netzwerk aus mindestens einem Widerstand und mindestens einem Kondensator, wobei der mindestens eine Kondensator abhängig von einem Pegel des Komparatorausgangssignals, insbesondere über den Widerstand, geladen und entladen wird, wobei der mindestens eine Widerstand mit dem Komparatorausgang unmittelbar elektrisch verbunden ist und ein Knoten zwischen dem mindestens einen Widerstand und mindestens einen Kondensator mit dem zweiten Eingang des Komparators unmittelbar elektrisch verbunden ist;

- eine Schalteinrichtung zum wechselweisen gesteuerten Anlegen des Referenzspannungspotenzials bzw. der Referenzspannung oder des Messspannungspotenzials bzw. der Messspannung an den ersten Eingang des Komparators, so dass ein zyklisches Laden und Entladen des mindestens einen Kondensators erreicht wird, und
- eine Zeit- oder Frequenzmesseinheit zum Messen einer Periodendauer oder einer Frequenz eines Komparatorausgangssignals als Angabe zu dem Messspannungspotenzial bzw. der Messspannung.

Weiterhin können der Komparator und die Schalteinrichtung so miteinander verbunden sein, dass bei Erreichen des Referenzspannungspotenzial durch ein von einem Kondensatorspannungspotenzial abhängiges Potenzial im RC-Netzwerk bzw. bei Erreichen der Referenzspannung durch eine von einer Kondensatorspannung abhängige Spannung im RC-Netzwerk ein Umschalten durch die Schalteinrichtung zum Anlegen des Messspannungspotenzials bzw. der Messspannung an den ersten Eingang des Komparators erfolgt.

Entsprechend können der Komparator und die Schalteinrichtung so miteinander verbunden sein, dass bei Erreichen des Messspannungspotenzial durch das von einem Kondensatorspannungspotenzial abhängige Potenzial im RC-Netzwerk bzw. bei Erreichen der Messspannung durch eine von einer Kondensatorspannung abhängige Spannung im RC-Netzwerk ein Umschalten durch die Schalteinrichtung zum Anlegen des Referenzspannungspotenzials bzw. der Referenzspannung an den ersten Eingang des Komparators erfolgt.

Es kann vorgesehen sein, dass die Referenzspannungsquelle, der Komparator, die Schalteinrichtung und eine Zeit- oder Frequenzmesseinheit in einem Mikrocontroller umfasst, implementiert oder integriert sind.

Die obige Spannungsmessanordnung kann von einem Mikrocontroller ausgehen, der in an sich bekannter Weise eine Referenzspannungsquelle, z.B. einen Digital-AnalogWandler zur Bereitstellung einer Referenzspannung, eine Schalteinrichtung, wie z.B. einen Analog-Multiplexer, einen Komparator und eine Zeit- oder Frequenzmesseinheit aufweist.

Die obige Spannungsmessanordnung ermöglicht in geschickter Weise die Nutzung von Komponenten eines Mikrocontrollers zum Aufbau einer hochauflösenden Differenzspannungsmessung bezüglich eines beliebig wählbaren oder fest vorgegebenen Referenzspannungspotenzials. Es wird dadurch auch die Messung von Messspannungen in kleinen Messbereichen mit hoher Auflösung ermöglicht.

Herkömmliche Spannungsmessschaltungen in Mikrocontrollern sind für einen festgelegten Messbereich ausgelegt und digitalisieren eine analoge Messspannung bezogen auf ein Massepotenzial innerhalb des Spannungsmessbereichs. Dies führt bei Messspannungen, die nur innerhalb eines kleineren Teil des Messbereichs variieren zu einer eingeschränkten relativen Auflösung dieses Bereichs. Dieses Problem wird in der Regel durch eine Skalierung des Bereichs von möglichen Messspannungen durch eine Vorverstärkung umgangen. Dazu wird eine Verstärkerstufe verwendet, die jedoch die Genauigkeit der Spannungsmessung aufgrund von Verstärkungsfehlern, Offset-Fehlern, zusätzlichen Störeinflüssen, beeinträchtigt. Weiterhin bedeutet dies einen höheren Schaltungsaufwand.

Die obige Spannungsmessanordnung sieht die Nutzung eines Mikrocontrollers vor, der wechselweise zum Beispiel mithilfe einer Schalteinrichtung (Analog-Multiplexer) ein Referenzspannungspotenzial (hierin auch Referenzspannung bezogen auf ein Massepotenzial genannt) oder ein zu messendes Messspannungspotenzial (hierin auch Messspannung bezogen auf ein Massepotenzial genannt) an einen nicht-invertierenden ersten Eingang des Komparators anlegt. Das Referenzspannungspotenzial bzw. die Referenzspannung liegt zwischen einem hohen Versorgungspotenzial und einem niedrigen Versorgungspotenzial bzw. die Referenzspannung ist geringer als die Versorgungsspannung. Die Schalteinrichtung/der Analog-Multiplexer wird durch das Komparatorausgangssignal gesteuert, so dass abhängig von dem Pegel des Komparatorausgangssignals die Referenzspannung oder die Messspannung an den nicht-invertierenden zweiten Eingang des Komparators angelegt wird.

Weiterhin ist der Komparatorausgang mit einem RC-Glied gekoppelt, so dass das RC-Glied zwischen dem Komparatorausgang und einem Massepotenzial angeordnet ist. Auf diese Weise wird eine Kapazität des RC-Glieds bei einem hohen Pegel (hohes Versorgungspotenzial) des Komparatorausgangssignals geladen und bei einem niedrigen Pegel (niedriges Versorgungspotenzial, das dem Massepotenzial entsprechen kann) entladen. Das Kondensatorpotenzial wird dabei an den invertierenden (zweiten) Eingang des Komparators angelegt.

Der Ausgang des Komparators liefert einen hohen Pegel des Komparatorausgangssignals bei einer positiven Spannungsdifferenz zwischen dem nicht-invertierenden ersten und invertierenden zweiten Eingang des Komparators und entsprechend einen niedrigen Pegel bei einer negativen Spannungsdifferenz. Ein hoher Pegel des Komparatorausgangssignals schaltet die Schalteinrichtung bzw. den Analog-Multiplexer so, dass das Messspannungspotenzial an den nicht-invertierenden Eingang des Komparators angelegt wird. Bei einem niedrigen Pegel des Komparatorausgangssignals wird dann das Referenzspannungspotenzial an den nicht-invertierenden Eingang des Komparators angelegt.

Im Messbetrieb ergibt sich ein periodisches Komparatorausgangssignal, dessen Frequenz und/oder Periodendauer gemessen werden kann. Dazu kann eine Zeit- oder Frequenzmesseinheit in Form eines Counters, Zeitmessers oder dergleichen im Mikrocontroller verwendet werden, die üblicherweise Bestandteil von herkömmlichen Mikrocontrollern sind. Die resultierende Periodendauer oder Frequenz des Komparatorausgangssignal ist abhängig von der gemessenen Messspannung.

Gemäß einer Ausführungsform können das Referenzspannungspotenzial bzw. die Referenzspannung und/oder die Zeitkonstante des RC-Netzwerks so gewählt sein, dass bei vorgegebenem Messbereich des Messspannungspotenzials bzw. der Messspannung sich eine Frequenzdifferenz (maximale Frequenz fmax - minimale Frequenz fmin) des Komparatorausgangssignals von z.B. einer Dekade ergibt. Theoretisch können beliebige Frequenzen eingestellt werden. Jedoch soll in der Praxis ein Kompromiss zwischen Genauigkeit, Schnelligkeit und Umsetzbarkeit (im Sinne der Spezifikationen des Komparators, Zählern des Mikrocontrollers etc.) gefunden werden. Entscheidend für die Bestimmung der Auflösung ist die Messgenauigkeit der Frequenz. Rechenbeispiel: Taktfreuenz des Mikrocontrollers fCPU=64MHz, die zugleich auch als Zählerfrequenz des Zeitmessers, fmin=1kHz, fmax=10kHz dient:

N1=64MHz/1kHz=64000 Takte (bei einer oberen Messspannung)
N2=64MHz/10kHz=6400 Takte (bei einer unteren Messpannung)
Der Messbereich zwischen der oberen und unteren Messspannung entspricht N2-N1=57600 Takten. Dies ermöglicht eine Auflösung von 15,8Bit

Die obige Spannungsmessanordnung ermöglicht die Nutzung von Mikrocontrollern für eine Spannungsmessung, insbesondere wenn diese keinen oder einen nur geringauflösenden Analog-/Digitalwandler aufweisen oder nur ein bezogen auf die Versorgungsspannung kleiner Messbereich vermessen werden soll. Zudem kann der Messbereich variabel eingestellt werden, insbesondere durch die Wahl des Referenzspannungspotenzials als z.B. untere Spannungsschwelle, anders als bei herkömmlichen A/D-Wandlern in Mikrocontrollern, welche sich an dem niedrigen Versorgungsspannungspotenzial orientieren. Zudem können Offset-Fehler begrenzt werden, indem nur ein Komparator verwendet wird und Verstärkungsfehler durch direkte Nutzung der Messspannung, d.h. ohne zusätzliche Verstärkung der Messspannung, gänzlich vermieden werden können.

Im Gegensatz zum Dual-Slope-Wandler zur Spannungsmessung wird bei der obigen Spannungsmessanordnung kein Integrator, sondern ein RC-Netzwerk benutzt. Der Komparatoreingang wird zwischen zwei Spannungsschwellen geschaltet, während beim Dual-Slope-Verfahren der Integratoreingang geschaltet wird. Insbesondere bietet die obige Spannungsmessanordnung dadurch den Vorteil, dass diese somit aus weniger elektrischen Komponenten besteht und anders als beim Dual-Slope Verfahren eine Frequenzmessung einfacher und genauer (z.B. durch Taktzählung innerhalb einer konstanten Torzeit) als eine reine Zeitmessung ist. Weiterhin werden bei der obigen Spannungsmessanordnung das Messspannungspotenzial sowie das Referenzspannungspotenzial mit demselben hochohmigen ersten (z.B. nicht-invertierenden) Eingang des Komparators verbunden, so dass kein zusätzlicher Impedanzwandler notwendig ist, wie dies bei anderen Spannungsmessanordnungen der Fall ist. Dadurch wird die Belastung der Messspannung reduziert.

Kurzbeschreibung der Zeichnungen

Ausführungsformen werden nachfolgend anhand der beigefügten Zeichnungen näher erläutert. Es zeigen:

Figur 1    eine schematische Darstellung einer Spannungsmessanordnung mit einem Mikrocontroller; und

Figur 2    ein Signal-Zeit-Diagramm zur Veranschaulichung des Signalverlaufs des Komparatorausgangssignals und der Kondensatorspannung.

Beschreibung von Ausführungsformen

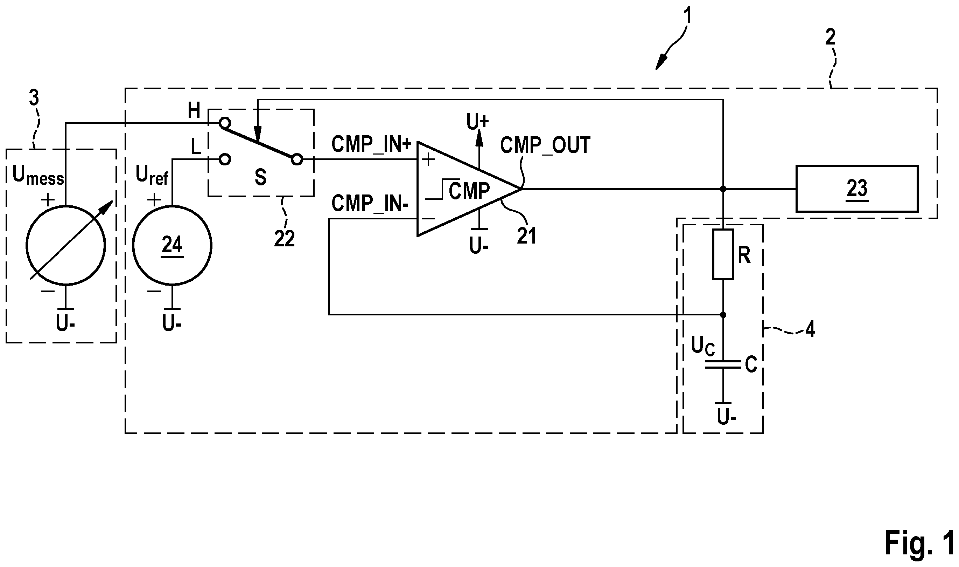

Figur 1 zeigt eine schematische Darstellung einer Spannungsmessanordnung 1 mit einem Mikrocontroller 2. Der Mikrocontroller 2 dient zur Steuerung oder allgemein zum Betreiben eines technischen Systems, bei dem von extern eine Messspannung $U_{mess}$, beispielsweise eines Sensors 3, bereitgestellt werden. Die Messspannung $U_{mess}$ kann beispielsweise eine Spannung, die aus einem ohmschen Widerstand eines Dehnungsmessstreifens abgeleitet ist, oder dergleichen sein. Ziel ist es, in dem Mikrocontroller 2 ein digitalisiertes Sensorsignal zu erhalten, das mit hoher Auflösung die Messspannung $U_{mess}$ angibt.

Der Mikrocontroller 2 weist in an sich bekannter Weise logische und elektronische Komponenten auf, von denen nachfolgend ein Komparator 21, ein Analog-Multiplexer 22 und eine Zeit- oder Frequenzmesseinheit 23 zur Zeit- oder Frequenzmessung verwendet wird.

Der Komparator 21 ist in an sich bekannter Weise ausgebildet und weist einen invertierenden CMP_IN- und nicht-invertierenden Eingang CMP_IN+ auf. Der Komparator 21 wird weiterhin über die Versorgungsspannung $U_{vers}$ =U+ - U- des Mikrocontrollers 2 versorgt. Die Versorgungsspannung $U_{vers}$ wird als Spannungsdifferenz zwischen einem hohen Versorgungspotenzial U+ und einem niedrigen Versorgungspotenzial U-, das insbesondere als Massepotenzial dient, bereitgestellt. Der Komparator 21 gibt abhängig von dem Vorzeichen der Spannungsdifferenz zwischen dem nicht-invertierenden (ersten) Eingang CMP_IN+ und invertierenden (zweiten) Eingang CMP_IN- einen niedrigen Pegel eines Ausgangssignals am Komparatorausgang CMP_OUT bei negativer Spannungsdifferenz und einen hohen Pegel des Ausgangssignals des Komparators 21 bei positiver Spannungsdifferenz aus.

Der Komparatorausgang CMP_OUT ist mit einem RC-Glied 4 als mögliches RC-Netzwerk als Reihenschaltung zwischen einem Widerstand R und einem Kondensator C verbunden. Insbesondere ist der Komparatorausgang CMP_OUT direkt mit einem ersten Anschluss des Widerstands R elektrisch verbunden. Ein zweiter Anschluss des Widerstands R ist direkt mit einem ersten Anschluss des Kondensators C elektrisch verbunden. Ein zweiter Anschluss des Kondensators C ist direkt mit dem niedrigen Versorgungspotenzial U-, beispielsweise einem Massepotenzial, elektrisch verbunden.

Der zweite Anschluss des Widerstands R und der erste Anschluss des Kondensators C sind direkt mit dem invertierenden Eingang CMP_IN- des Komparators 21 elektrisch verbunden.

Der nicht-invertierende Eingang CMP_IN+ des Komparators 21 ist mit einem Ausgang eines Analog-Multiplexers 22 verbunden. Der Analog-Multiplexer 22 wird abhängig von dem Ausgangssignal am Komparatorausgang CMP_OUT des Komparators 21 geschaltet.

Eingangsseitig des Analog-Multiplexers 22 liegen ein Referenzspannungspotenzial bzw. eine Referenzspannung $U_{ref}$ bezogen auf das niedrige Versorgungspotenzial U- und ein Messspannungspotenzial $U_{mess}$ bzw. eine Messspannung bezogen auf das niedrige Versorgungspotenzial U- an. Das Referenzspannungspotenzial $U_{ref}$ wird durch eine einstellbare Referenzspannungsquelle 24 in dem Mikrocontroller 2 bereitgestellt.

Beim Einschalten ist der Analog-Multiplexer 22 so geschaltet, dass das Messspannungspotenzial $U_{mess}$ an dem nicht-invertierenden Eingang CMP_IN+ des Komparators 21 anliegt. Der Kondensator C ist entladen. Somit ergibt sich eine positive Spannungsdifferenz an den Komparatoreingängen und somit liegt der Komparatorausgang CMP_OUT auf einem hohen Pegel, also dem hohen Versorgungspotenzial U+.

Der Komparatorausgang des Komparators 21 liegt auf dem hohen Versorgungspotenzial U+. Durch die Kopplung mit dem RC-Glied 4 wird der Kondensator C mit der Zeitkonstanten RxC geladen. Wenn der invertierende Eingang CMP_IN- des Komparators 21 die Messspannung $U_{mess}$ erreicht, schaltet der Komparator 21 seinen Ausgang auf den niedrigen Pegel, d.h. das niedrige Versorgungspotenzial U- um, und der Kondensator C beginnt sich zu entladen. Im selben Moment wird, getriggert durch den Wechsel des Pegels des Komparatorausgangssignals der Analog-Multiplexer 22 umgeschaltet und somit das Referenzpotenzial $U_{ref}$ an den nicht-invertierenden Eingang CMP_IN+ des Komparators 21 angelegt. Der Kondensator C entlädt sich, bis die untere Schwelle, die durch das Referenzpotenzial $U_{ref}$ am nicht-invertierenden Eingang CMP_IN+ des Komparators 21 angelegt ist, erreicht ist. Ist dies der Fall, schaltet der Komparatorausgang auf den hohen Pegel, d.h. das hohe Versorgungspotenzial U+, und aufgrund des Pegelwechsels wird der Analog-Multiplexer 22 entsprechend erneut umgeschaltet. Der Zyklus beginnt nun von vorne.

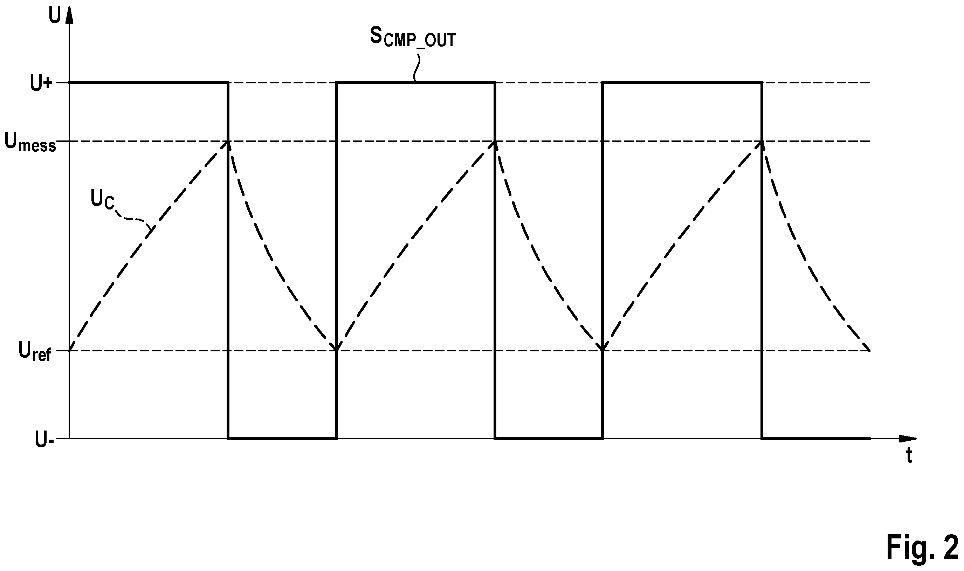

Wie in Figur 2 gezeigt, ergibt sich daraus ein periodischer Signalverlauf. Figur 2 zeigt dazu den Verlauf der Kondensatorspannung $U_C$ und den Pegel des Komparatorausgangssignals $S_{CMP\_OUT}$ am Komparatorausgang CMP_OUT.

Es ergibt sich folgende Beziehung für die Periodendauer T des periodischen Signals am Komparatorausgang.

$$T = R \cdot C \cdot ln\left(\frac{U_+ - U_{ref}}{U_+ - U_{mess}} \cdot \frac{U_{mess}}{U_{ref}}\right)$$

Es ergibt sich, dass, je näher die Messspannung $U_{mess}$ an der Referenzspannung $U_{ref}$ liegt, also je kleiner die Differenzspannung, desto höher ist die sich am Komparatorausgang CMP_OUT ergebende Frequenz des periodischen Signals $S_{CMP\_OUT}$. Weiterhin kann durch geeignete Wahl des Widerstands R, des Kondensators C, sowie der Referenzspannung der Frequenzbereich des periodischen Komparatorausgangssignals beliebig angepasst werden. Der Komparatorausgang CMP_OUT ist zudem mit der Zeit- oder Frequenzmesseinheit 23 verbunden, um die Periodendauer bzw. die Frequenz, beispielsweise durch einen Frequenzzähler, zu messen. Diese stehen in direktem Zusammenhang mit der Messspannung $U_{mess}$, so dass die Messspannung $U_{mess}$ durch die Angabe der Periodendauer oder der Frequenz bestimmt werden kann sofern die übrigen Größen (R, C, U+, Uref) auch bekannt sind.

**Patentansprüche**

1. Spannungsmessanordnung (1), insbesondere zur Nutzung mit einem Mikrocontroller (2), zum Messen und Digitalisieren eines Messspannungspotenzials oder einer Messspannung ($U_{mess}$) mit hoher Präzision, umfassend:

    - eine einstellbare Referenzspannungsquelle (24) zum Bereitstellen eines Referenzspannungspotenzial oder einer Referenzspannung ($U_{ref}$),
    - einen Komparator (21) mit einem ersten Eingang (CMP_IN+), einem zweiten Eingang und einen Komparatorausgang (CMP_OUT) zum Ausgeben eines hohen Pegels oder eines niedrigen Pegels eines Komparatorausgangssignals abhängig von einem Vorzeichen einer Spannungsdifferenz zwischen dem ersten und dem zweiten Eingang (CMP_IN+, CMP_IN-);
    - ein RC-Netzwerk (4), das mindestens einen Widerstand (R) und mindestens einen Kondensator (C) aufweist, wobei der mindestens eine Kondensator (C) abhängig von einem Pegel des Komparatorausgangssignals geladen und entladen wird, wobei der mindestens eine Widerstand mit dem Komparatorausgang (CMP_OUT) unmittelbar elektrisch verbunden ist und ein Knoten zwischen dem mindestens einen Widerstand (R) und mindestens einen Kondensator (C) mit dem zweiten Eingang (CMP_IN-) des Komparators (21) unmittelbar elektrisch verbunden ist;
    - eine Schalteinrichtung (22) zum wechselweisen gesteuerten Anlegen des Referenzspannungspotenzials bzw. der Referenzspannung ($U_{ref}$) oder des Messspannungspotenzials bzw. der Messspannung ($U_{mess}$) an den ersten Eingang (CMP_IN+) des Komparators (21), so dass ein zyklisches Laden und Entladen des mindestens einen Kondensators (C) erreicht wird, und
    - eine Zeit- oder Frequenzmesseinheit (23) zum Messen einer Periodendauer oder einer Frequenz eines periodischen Komparatorausgangssignals als Angabe zu der Höhe des Messspannungspotenzials bzw. der Messspannung ($U_{mess}$).

2. Spannungsmessanordnung (1) nach Anspruch 1, wobei der Komparator (21) und die Schalteinrichtung (22) so miteinander verbunden sind, dass bei Erreichen des Referenzspannungspotenzials durch das Kondensatorspannungspotenzial bzw. bei Erreichen der Referenzspannung ($U_{ref}$) durch die Kondensatorspannung ein Umschalten durch die Schalteinrichtung (22) zum Anlegen des Messspannungspotenzials bzw. der Messspannung an den ersten Eingang (CMP_IN+) des Komparators (21) erfolgt.

3. Spannungsmessanordnung (1) nach Anspruch 1 oder 2, wobei der Komparator (21) und die Schalteinrichtung (22) so miteinander verbunden sind, dass bei Erreichen des Messspannungspotenzial durch das Kondensatorspannungspotenzial bzw. bei Erreichen der Messspannung ($U_{mess}$) durch die Kondensatorspannung ein Umschalten durch die Schalteinrichtung (22) zum Anlegen des Referenzspannungspotenzials bzw. der Referenzspannung ($U_{ref}$) an den ersten Eingang (CMP_IN+) des Komparators (21) erfolgt.

**4.** Spannungsmessanordnung (1) nach einem der Ansprüche 1 bis 3, wobei die einstellbare Referenzspannungsquelle (24), der Komparator (21), die Schalteinrichtung (22) und eine Zeit- oder Frequenzmesseinheit in einem Mikrocontroller (2) umfasst oder als mikroelektronische Schaltung integriert sind.

**5.** Spannungsmessanordnung (1) nach einem der Ansprüche 1 bis 4, wobei die Schalteinrichtung einen Analog-Multiplexer umfasst.

**6.** Spannungsmessanordnung (1) nach einem der Ansprüche 1 bis 5, wobei der erste Eingang des Komparators (21) einem nicht-invertierenden Eingang (CMP_IN+) und der zweite Eingang des Komparators (21) einem invertierenden Eingang (CMP_IN-) entspricht.

**7.** Spannungsmessanordnung (1) nach einem der Ansprüche 1 bis 6, wobei das Referenzspannungspotenzial bzw. die Referenzspannung ($U_{ref}$) und/oder die Zeitkonstante des RC-Netzwerks (4) so gewählt sind, dass bei vorgegebenem Messbereich des Messspannungspotenzials bzw. der Messspannung ($U_{mess}$) sich eine Frequenzdifferenz des Komparatorausgangssignals zwischen den resultierenden Frequenzen für das Messspannungspotenzial bzw. der Messspannung ($U_{mess}$) an einer obere und einer untere Grenze des Messbereichs insbesondere von zwischen einer und drei Dekaden, vorzugsweise zwischen einer und zwei Dekaden, ergibt.

**Claims**

**1.** Voltage measurement arrangement (1), in particular for use with a microcontroller (2), for measuring and digitizing a measurement voltage potential or a measurement voltage ($U_{mess}$) with high precision, comprising:

- an adjustable reference voltage source (24) for providing a reference voltage potential or a reference voltage ($U_{ref}$),
- a comparator (21) with a first input (CMP_IN+), a second input and a comparator output (CMP_OUT) for outputting a high level or a low level of a comparator output signal depending on a sign of a voltage difference between the first and second inputs (CMP_IN+, CMP_IN-);
- an RC network (4) comprising at least one resistor (R) and at least one capacitor (C), wherein the at least one capacitor (C) is charged and discharged depending on a level of the comparator output signal, wherein the at least one resistor is directly electrically connected to the comparator output (CMP_OUT) and a node between the at least one resistor (R) and the at least one capacitor (C) is directly electrically connected to the second input (CMP_IN-) of the comparator (21);
- a switching device (22) for an alternately controlled applying of the reference voltage potential or the reference voltage ($U_{ref}$) or the measurement voltage potential or the measurement voltage ($U_{mess}$) to the first input (CMP_IN+) of the comparator (21), so that a cyclic charging and discharging of the at least one capacitor (C) is achieved, and
- a time or frequency measurement unit (23) for measuring a period duration or a frequency of a periodic comparator output signal as an indication of the magnitude of the measurement voltage potential or the measurement voltage ($U_{mess}$).

**2.** Voltage measurement arrangement (1) according to claim 1, wherein the comparator (21) and the switching device (22) are connected to one another in such a way that, when the capacitor voltage potential reaches the reference voltage potential or when the capacitor voltage reaches the reference voltage ($U_{ref}$), a switching by the switching device (22) takes place to apply the measurement voltage potential or the measurement voltage to the first input (CMP_IN+) of the comparator (21).

**3.** Voltage measurement arrangement (1) according to claim 1 or 2, wherein the comparator (21) and the switching device (22) are connected to one another in such a way that, when the capacitor voltage potential reaches the measurement voltage potential or when the capacitor voltage reaches the measurement voltage ($U_{mess}$), a switching by the switching device (22) takes place to apply the reference voltage potential or the reference voltage ($U_{ref}$) to the first input (CMP_IN+) of the comparator (21).

**4.** Voltage measurement arrangement (1) according to any one of claims 1 to 3, wherein the adjustable reference voltage source (24), the comparator (21), the switching device (22) and a time or frequency measurement unit are comprised in a microcontroller (2) or are integrated as a microelectronic circuit.

**5.** Voltage measurement arrangement (1) according to any one of claims 1 to 4, wherein the switching device comprises an analog multiplexer.

**6.** Voltage measurement arrangement (1) according to any one of claims 1 to 5, wherein the first input of the comparator (21) corresponds to a non-inverting input (CMP_IN+) and the second input of the comparator (21) corresponds to an inverting input (CMP_IN-).

7. Voltage measurement arrangement (1) according to any one of claims 1 to 6, wherein the reference voltage potential or the reference voltage ($U_{ref}$) and/or the time constant of the RC network (4) are selected such that, for a predetermined measurement range of the measurement voltage potential or the measurement voltage ($U_{mess}$), a frequency difference of the comparator output signal between the resulting frequencies for the measurement voltage potential or the measurement voltage ($U_{mess}$) at an upper and a lower limit of the measurement range is in particular between one and three decades, preferably between one and two decades. ]

**Revendications**

1. Dispositif de mesure de tension (1), en particulier pour une utilisation avec un microcontrôleur (2), destiné à mesurer et à numériser un potentiel de tension de mesure ou une tension de mesure ($U_{mess}$) avec une grande précision, comprenant :

- une source de tension de référence réglable (24) pour fournir un potentiel de tension de référence ou une tension de référence ($U_{ref}$),
- un comparateur (21) avec une première entrée (CMP_IN+), une deuxième entrée et une sortie de comparateur (CMP_OUT) pour délivrer un niveau haut ou un niveau bas d'un signal de sortie de comparateur en fonction du signe d'une différence de tension entre la première et la deuxième entrée (CMP_IN+, CMP_IN-);
- un réseau RC (4), qui comprend au moins une résistance (R) et au moins un condensateur (C), le au moins un condensateur (C) étant chargé et déchargé en fonction d'un niveau du signal de sortie du comparateur, la au moins une résistance étant directement connectée électriquement à la sortie du comparateur (CMP_OUT) et un noeud entre la au moins une résistance (R) et le au moins un condensateur (C) étant relié électriquement de manière directe à la deuxième entrée (CMP_IN-) du comparateur (21);
- un dispositif de commutation (22) pour appliquer de manière alternée et contrôlée le potentiel de tension de référence ou la tension de référence ($U_{ref}$) ou le potentiel de tension de mesure ou la tension de mesure ($U_{mess}$) à la première entrée (CMP_IN+) du comparateur (21), de manière à obtenir une chargement et un déchargement cycliques du au moins un condensateur (C) sont obtenus, et
- une unité de mesure de temps ou de fréquence (23) pour mesurer une durée de période ou une fréquence d'un signal périodique de sortie de comparateur comme indication du niveau du potentiel de tension de mesure ou de la tension de mesure ($U_{mess}$).

2. Dispositif de mesure de tension (1) selon la revendication 1, le comparateur (21) et le dispositif de commutation (22) étant reliés entre eux de telle sorte que, lors de l'atteinte du potentiel de tension de référence par le potentiel de tension du condensateur ou lors de l'atteinte de la tension de référence ($U_{ref}$) par la tension du condensateur, une commutation par le dispositif de commutation (22) pour appliquer le potentiel de tension de mesure ou la tension de mesure à la première entrée (CMP_IN+) du comparateur (21) a lieu.

3. Dispositif de mesure de tension (1) selon l'une quelconque des revendications 1 ou 2, le comparateur (21) et le dispositif de commutation (22) étant reliés entre eux de telle sorte que, lors de l'atteinte du potentiel de tension de mesure par le potentiel de tension du condensateur ou lors de l'atteinte de la tension de mesure ($U_{mess}$) par la tension du condensateur, une commutation par le dispositif de commutation (22) pour appliquer le potentiel de tension de référence ou la tension de référence ($U_{ref}$) à la première entrée (CMP_IN+) du comparateur (21) a lieu.

4. Dispositif de mesure de tension (1) selon l'une quelconque des revendications 1 à 3, la source de tension de référence réglable (24), le comparateur (21), le dispositif de commutation (22) et une unité de mesure de temps ou de fréquence étant compris dans un microcontrôleur (2) ou intégrés sous forme de circuit microélectronique.

5. Dispositif de mesure de tension (1) selon l'une quelconque des revendications 1 à 4, le dispositif de commutation comprenant un multiplexeur analogique.

6. Dispositif de mesure de tension (1) selon l'une quelconque des revendications 1 à 5, la première entrée du comparateur (21) correspondant à une entrée non inverseuse (CMP_IN+) et la deuxième entrée du comparateur (21) correspondant à une entrée inverseuse (CMP_IN-).

7. Dispositif de mesure de tension (1) selon l'une quelconque des revendications 1 à 6, le potentiel de tension de référence ou la tension de référence ($U_{ref}$) et/ou la constante de temps du réseau RC (4) étant choisis de telle sorte que, pour une plage de mesure prédéfinie du potentiel de tension de mesure ou de la tension de mesure ($U_{mess}$), il en résulte une différence de fréquence du signal de sortie du comparateur entre les fréquences résultantes pour le potentiel de tension de mesure ou la tension de mesure

($U_{mess}$) à une limite supérieure et à une limite inférieure de la plage de mesure, en particulier comprise entre une et trois décades, de préférence entre une et deux décades.

Fig. 1

Fig. 2

EP 4 293 915 B1

**IN DER BESCHREIBUNG AUFGEFÜHRTE DOKUMENTE**

**In der Beschreibung aufgeführte Patentdokumente**

- FR 2977748 A1
- US 6348798 B1
- DE 2826723 A1
- US 2014015513 A1
- GB 1397288 A